(19) Europäisches Patentamt

European Patent Office

Office européen des brevets

(11) Veröffentlichungsnummer : **0 406 809 B1**

(12) **EUROPÄISCHE PATENTSCHRIFT**

(45) Veröffentlichungstag der Patentschrift :
**15.12.93 Patentblatt 93/50**

(21) Anmeldenummer : **90112697.9**

(22) Anmeldetag : **03.07.90**

(51) Int. Cl.$^5$ : **G01R 31/08,** G01R 27/16

(54) Verfahren und Vorrichtung zur Ermittlung der betriebsfrequenten Schleifenimpedanz.

(30) Priorität : **03.07.89 DD 330322**

(43) Veröffentlichungstag der Anmeldung :
**09.01.91 Patentblatt 91/02**

(45) Bekanntmachung des Hinweises auf die
Patenterteilung :
**15.12.93 Patentblatt 93/50**

(84) Benannte Vertragsstaaten :
**DE FR GB SE**

(56) Entgegenhaltungen :
**EP-A- 0 106 790**
**EP-A- 0 284 546**
**DE-A- 3 626 400**
**TOSHIBA REVIEW. Nr. 148, 1984, TOKYO JP**
**Seiten 11 - 14; MURAOKA ET AL: 'MICROPRO-**
**CESSOR-BASED FAULT LOCATOR'**
**IEEE TRANSACTIONS ON POWER DELIVERY.**
**Bd. 3, Nr. 2, April 1988, NEW YORK US Seiten**
**496 - 502; LAWRENCE AND WASER: 'TRANS-**
**MISSION LINE FAULT LOCATION...'**

(73) Patentinhaber : **VEAG Vereinigte**
**Energiewerke AG**
**Allee der Kosmonauten 29**
**D-12681 Berlin (DE)**

(72) Erfinder : **Jurisch, Andreas, Dipl.-Ing.**
**Rudeltstrasse 2**
**DDR-8210 Freital (DD)**
Erfinder : **Jurisch, Petra, Dipl.-Ing.**
**Rudeltstrasse 2**
**DDR-8210 Freital (DD)**

(74) Vertreter : **Zinken-Sommer, Rainer**
**VEAG Vereinigte Energiewerke AG Referat**
**Patent- und Lizenzwesen Allee der**
**Kosmonauten 29**
**O-1140 Berlin (DE)**

EP 0 406 809 B1

Anmerkung : Innerhalb von neun Monaten nach der Bekanntmachung des Hinweises auf die Erteilung des europäischen Patents kann jedermann beim Europäischen Patentamt gegen das erteilte europä-ische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patent-übereinkommen).

## Beschreibung

Die Erfindung betrifft ein Verfahren sowie eine Schaltungsanordnung zur Ermittlung der betriebsfrequenten Impedanz einer Leiterschleife, die besonders bei der Kurzschlußfehlerortung mittels Distanzschutz, insbesondere bei der hierfür notwendigen Ermittlung der Fehlerimpedanz der betroffenen Leitung, anwendbar sind.

Aus DE-A-32 35 239 ist ein Fehlerortungsverfahren bekannt, welches das Wanderwellendistanzschutzprinzip realisiert, wobei die transienten Vorgänge beim Fehlereintritt ausgewertet werden. Nachteilig bei diesem Verfahren ist, daß es von einer totalen Reflexion der durch einen Fehlereintritt verursachten Welle am Meßort ausgeht. Das bedeutet aber, daß am Relaiseinbauort ein drastischer Wechsel des Wellenwiderstandes der Leitung erfolgen muß. Für eine Doppelleitung ist dieses Verfahren bereits nicht mehr anwendbar.

Das in DE-A-29 32 929 vorgeschlagene Fehlerortungsverfahren beruht auf dem Superpositionsprinzip und der Vierpoldarstellung einer homogenen Leitung im Frequenzbereich. Es werden Rückspeisungen auf den Fehlerwiderstand vom anderen Leitungsende eliminiert und Meßfehler weitestgehend vermieden. Nachteilig ist die Notwendigkeit eines zusätzlichen Anregeblocks, der die Unterscheidung von fehlerfreier und fehlerbehafteter Leitung gestattet, um überhaupt Vor- und Nachfehlergrößen zu erhalten. Sind aperiodische Signalkomponenten in einem Stromsignal vorhanden, bereitet die Berechnung der komplexen Zeiger der Ströme Schwierigkeiten. Die ferner bei diesem bekannten Verfahren vorgesehene Iteration macht den arithmetischen Aufwand zur Realisierung schwer im voraus kalkulierbar.

Aus DE-A-36 26 400 ist ein Gerät bekannt, welches durch Berechnung der Strom-Spannungs-Kreuzkorrelationsfunktion des Leistungsspektrums, des Impedanzspektrums sowie der Spektren von Strom und Spannung auf den Anlagenzustand des zu überwachenden Objektes schließt und diese Größen in einem Bewertungsvektor zu einem Fehlersignal verknüpft.

Ein derartig hoher Aufwand ist für den Kurzschlußschutz von Freileitungen und Kabeln, die mit Wechselstrom technischer Frequenz (50 bzw. 60 Hz) betrieben werden, nicht tragbar, da bei einem Fehler des Schutzobjektes die Spektrallinie mit dem höchsten Energieinhalt bereits a priori bekannt ist.

Der Erfindung liegt die Aufgabe zugrunde, eine kostengünstige verfahrensmäßige und apparative Lösung zur Impedanzermittlung in Leiterschleifen hinsichtlich der Senkung des Projektierungs- und Materialaufwands bei der Primärtechnik anzugeben. Dabei soll mittels bereits vorhandener Stromwandler mit nichtlinearer Kennlinie die betriebsfrequente Impedanz der Leiterschleife genauer als mit bekannten Lösungen ermittelt und gleichzeitig durch fehlerminimierende Eigenschaften die Zahl der Fehlauslösungen des Distanzschutzes gesenkt werden können.

Die Aufgabe wird gemäß den Ansprüchen 1 und 2 gelöst.

Beim erfindungsgemäßen Verfahren wird der in bekannter Weise gemessene Spannungswert hinsichtlich der Nachbarsystembeeinflussung korrigiert; mit diesem korrigierten Wert wird mittels einer Filtereinrichtung 1. Ordnung ein Stromsignal erzeugt, das einen Schätzwert für den Primärstrom in der Leitung darstellt. Dieser Strom wird mittels eines nichtlinearen Stromwandlermodells in ein Stromsignal umgewandelt, welches den Schätzwert des meßbaren Sekundärstroms des Hauptstromwandlers repräsentiert. Das Modellfehlersignal, welches durch die Differenz von gemessenem und geschätztem Sekundärstrom bestimmt wird, ist zur Nachregelung der Parameter der Filtereinrichtung mittels einer an sich bekannten PE (prediction error)-Schätzeinrichtung verwendbar. Die Nachregelung erfolgt derart, daß der Modellfehler minimal wird. Aus den Parametern der Filtereinrichtung wird der betriebsfrequente Zeiger der diesem Koeffizientensatz und diesem Filterstrom entsprechenden Übertragungsfunktion ermittelt, dessen Reziprokwert der Impedanz der Leiterschleife entspricht.

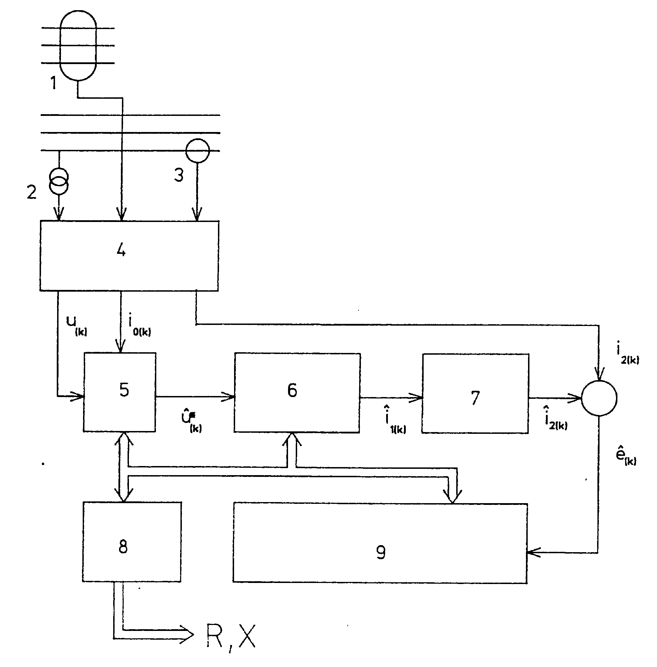

Die Erfindung wird nachstehend anhand eines Ausführungsbeispiels unter Bezug auf die Zeichnung näher erläutert.

## Ausführungsbeispiel

Im nachstehenden Ausführungsbeispiel sind folgende Abkürzungen verwendet:

$u_{ind}$     über der auszumessenden Leiterschleife durch das Nachbarsystem induzierte Spannung

M     Gegeninduktivität zwischen Nachbarsystem und auszumessender Leiterschleife

k     Koppelfaktor zwischen Nachbarsystem und auszumessender Leiterschleife

L     Selbstinduktivität zwischen Nachbarsystem und auszumessender Leiterschleife

$u^*$     um den Einfluß der Induktion aus den Nachbarsystem korrigierte Schleifenspannung

$i_o$     Nullstrom des Nachbarsystems

$i_H$     Strom durch die Hauptinduktivität des Primärstromwandlers

$L_H$     Hauptinduktivität des Primärstromwandlers

$R_B$       Ohmsche Bürde des Primärstromwandlers

$\underline{Y}$       komlexer Leitwert der auszumessenden Leiterschleife

$\underline{f_N}$       Netzfrequenz

$T_A$       Zeitdifferenz zwischen zwei Abtastungen.

Diese Symbole können durch folgende Indizierungen ergänzt sein:

$x_{(k+n)}$       Abtastwert der Größe x zum Zeitpunkt (k+n) $*T_A$

$\hat{x}$       Schätzwert der Größe x .

In der Zeichnung ist eine bevorzugte Ausführungsform der erfindungsgemäßen Schaltungsanordnung dargestellt, wobei der Signalfluß angegeben ist.

Die Schaltungsanordnung umfaßt einen Nullstromwandler $\underline{1}$ des Nachbarsystems, einen Spannungswandler $\underline{2}$ der auszumessenden Schleife, einen Hauptstromwandler $\underline{3}$ der auszumessenden Schleife und ein Meßwerterfassungssystem $\underline{4}$, das die Ausgangssignale des Nullstromwandlers $\underline{1}$, des Spannungswandlers $\underline{2}$ und des Hauptstromwandlers $\underline{3}$ zugeführt erhält und Ausgangssignale $u_{(k)}$ und $i_{o(k)}$ abgibt, die der erfaßten Spannung bzw. dem erfaßten Strom entsprechen und einer Einrichtung $\underline{5}$ zur Spannungssignalkorrektur zugeführt werden, die ihrerseits ein Ausgangssignal abgibt, das dem um den Einfluß der Induktion aus dem Nachbarsystem korrigierten Spannungswert $u_{(k)}^{*}$ entspricht. Dieses Signal wird in einer der Einrichtung $\underline{5}$ zur Spannungssignalkorrektur nachgeschalteten Filtereinrichtung $\underline{6}$, die ein Filter 1. Ordnung und vorzugsweise ein digitales Filter ist und das Leitungsmodell darstellt, in ein dem Strom $\hat{i}_{1(k)}$ entsprechendes Signal umgewandelt, das einen Schätzwert für den Primärstrom in der Leitung darstellt. In einem nachgeschalteten nichtlinearen Stromwandlermodell $\underline{7}$ wird daraus ein Stromsignal erzeugt, das den Schätzwert $\hat{i}_{2(k)}$ des meßbaren Sekundärstroms des Hauptstromwandlers 3 darstellt, das in einem Differenzbildner mit dem geschätzten Sekundärstrom $i_{2(k)}$ verglichen wird, dessen entsprechendes Signal vom Meßwerterfassungssystem $\underline{4}$ zugeführt wird.

Das der Differenz $\hat{e}_{(k)}$ von gemessenem und geschätztem Sekundärstrom entsprechende Modellfehlersignal wird einer PE-Schätzeinrichtung $\underline{9}$ zugeführt, die wechselseitig mit der Einrichtung $\underline{5}$ zur Spannungssignalkorrektur, der Filtereinrichtung $\underline{6}$ sowie einer Einrichtung $\underline{8}$ zur Transformation der Filterkoeffizienten in Verbindung steht, mit deren Ausgangssignalen die Parameter der Filtereinrichtung $\underline{6}$ so nachgeregelt werden, daß der Modellfehler minimal wird. Die Schaltungsanordnung ist so ausgebildet, daß aus den Parametern der Filtereinrichtung $\underline{6}$ der betriebsfrequente Zeiger der diesem Filterkoeffizientensatz und dieser Filterform entsprechenden Übertragungsfunktion ermittelt wird, dessen Reziprokwert der Impedanz der Leiterschleife entspricht.

Diese Schaltungsanordnung kann sowohl in festverdrahteter Form, etwa in Form einer applikationsspezifischen Hardware, als auch z.B. in Form einer programmierbaren Steuerung gerätetechnisch realisiert werden. Nach einer vorteilhaften Ausführungsform wird die Schaltungsanordnung als digitales Mikroprozessorsystem realisiert, das die oben erläuterten Funktionen der Einrichtung $\underline{5}$ zur Spannungssignalkorrektur, der Filtereinrichtung $\underline{6}$, des Stromwandlermodells $\underline{7}$, der Einrichtung $\underline{8}$ zur Transformation der Filterkoeffizienten und der PE-Schätzeinrichtung $\underline{9}$ sowie ggfs. auch des Meßwerterfassungssystem $\underline{4}$ übernimmt und die Impedanzwertermittlung durchführt.

Die Schaltungsanordnung kann ferner auch eine Ausgangs- bzw. Ausgabeeinrichtung und/oder eine Anzeigeeinrichtung aufweisen, mit denen Ergebniswerte z.B.ausgegeben, ausgedruckt und/oder angezeigt werden können.

Das Meßverfahren beruht auf einer Anwendung der Schätztheorie. Der wesentliche Vorteil des erfindungsgemäßen Verfahrens gegenüber bekannten Lösungen ist das adaptive Verhalten der im Verfahren eingesetzten Modelle gegenüber den Zuständen des Schutzobjekts bei gleichzeitiger Unempfindlichkeit des Verfahrens gegenüber aperiodischen Anteilen im Stromsignal. Das wird durch die Kombination eines auf einer Übertragungsfunktionsbeschreibung beruhenden Leitungsmodells mit einer auf A-priori-Information über die gemessenen Signale beruhenden Auswertevorschrift der geschätzten Filterparameter erreicht.

Das beschriebene Modell des zu identifizierenden Prozesses beinhaltet

- das Modell der induktiven Einkopplungen des Nachbarsystems durch die Einrichtung $\underline{5}$ zur Spannungssignalkorrektur,
- das Modell der Leitung selbst in Form der ein allgemeines Filter darstellenden Filtereinrichtung $\underline{6}$ und
- das Stromwandlermodell $\underline{7}$ zur Nachbildung des induktiven Hauptstromwandlers 3.

Die Spannungssignalkorrektur in der Einrichtung $\underline{5}$ beruht darauf, daß nur die Nullströme einer zur auszumessenden Leiterschleife parallel verlaufenden Drehstromleitung eine Beeinflussung hervorrufen. Die über der Leiterschleife gemessene Spannung wird als Summe des durch den Schleifenstrom hervorgerufenen Spannungsabfalls und der durch das Nachbarsystem induzierten Spannung betrachtet (Anwendung des Superpositionsprinzips). Das durch Induktionsvorgänge aus dem Nachbarsystem unbeeinflußte Spannungssi-

3

gnal erhält man durch Subtraktion der Induktionsspannung $u_{ind}$ von der gemessenen Spannung u. Die Induktionsspannung $u_{ind}$ kann aus der im Verfahren ermittelten Schleifeninduktivität L und dem gemessenen Nullstrom des Nachbarsystems wie folgt ermittelt werden:

$$u_{ind} = -M\frac{di_o}{dt} \qquad \text{mit } M = KL.$$

Die korrigierte Spannung u* ergibt sich also wie folgt aus den Abtastwerten von u und $i_o$ :

$$u^*_{(k)} = -kL\left[ i_{o(k)} - i_{o(k-1)} \right] T_A^{-1} + u_{(k)},$$

Diese korrigierte Spannung wird der Filtereinrichtung 6 als allgemeinem Filter 1. Ordnung mit folgenden Knotenpunktgleichungen zugeführt:

$$i_{1(k)} = x_{(k-1)} + \alpha_o u^*_{(k)}$$
$$\text{mit}$$
$$x_{(k)} = \alpha_1 u^*_{(k)} - \beta_1 i_{1(k)}$$

x : Zustandsvariable des Filters.

Dieses Filter realisiert ein beliebiges, nicht vorher festgelegtes Übertragungsverhalten. Dadurch wird im Gegensatz zu bisher bekannten Verfahren auch eine exakte Messung im fehlerfreien Fall der auszumessenden Leiterschleife garantiert. Das Leitungsmodell ist somit an den Kurzschlußfall genauso anpaßbar wie an einen kapazitiven Lastfall.

Das einen Schätzwert für den in der auszumessenden Leiterschleife fließenden, nicht meßbaren Primärstrom $i_1$ darstellende Ausgangssignal des Leitungsmodells wird einem vorzugsweise digitalen nichtlinearen Stromwandlermodell zur Verfügung gestellt, um den Schätzwert des meßbaren Sekundärstromes $i_2$ des in der auszumessenden Leiterschleife eingebauten Stromwandlers zu erhalten. Dieses Wandlermodell kann z. B. folgende Form haben:

$$\hat{i}_{2(k)} = \hat{i}_{1(k)} + \hat{i}_{H(k)}.$$

Der Magnetisierungsstrom des Hauptwandlers $i_H$ ist relativ einfach mit dem Runge-Kutta-Verfahren ermittelbar:

$$\hat{i}_{H(k)} = \frac{R_B T_A}{6}\left[ dih1 + dih2 + dih3 + dih4 \right]$$

mit:

$$dih1 = \frac{\hat{i}_{2(k)}}{L_H(i_{h(k)})}$$

$$dih2 = \frac{\hat{i}_{2(k+\tau)}}{L_H(i_{h(k)} + \tau\, dih1)}$$

$$dih3 = \frac{\hat{i}_{2(k+\tau)}}{L_H(i_{h(k)} + \tau\, dih2)}$$

$$dih4 = \frac{\hat{i}_{2(k+1)}}{L_H(i_{h(k)} + T_A\, dih1)}$$

$\tau = 0.5\, T_A$.

Das Ausgangssignal $\hat{i}_{2(k)}$ des Wandlermodells kann nun der PE-Schätzeinrichtung des zu messenden Sekundärstroms zur Verfügung gestellt werden:

$$\underline{\Theta}_{(k)} = \underline{\Theta}_{(k-1)} + \mathbb{P}_{(k)}\underline{\Gamma}^T_{(k)}\left[ i_{2(k)} - \hat{i}_{2(k)} \right]$$

$$\mathbb{P}_{(k)} = \frac{1}{\lambda}\left[ \mathbb{P}_{(k-1)} - \mathbb{P}_{(k-1)}\underline{\Gamma}^T_{(k)}(\lambda + \underline{\Gamma}_{(k)}\mathbb{P}_{(k-1)}\underline{\Gamma}^T_{(k)})^{-1}\underline{\Gamma}_{(k)}\mathbb{P}_{(k-1)} \right]$$

mit

$$\underline{\Gamma}_{(k)} = \frac{d\,\hat{i}_{2(k)}}{d\,\underline{\Theta}} \qquad \mathbb{P}\ \text{Präzisionsmatrix}$$

$$\underline{\Theta} = \begin{bmatrix} \alpha_o & \alpha_1 & \beta_1 \end{bmatrix}^T \qquad \lambda\ \text{Vergessensfaktor .}$$

Der Einsatz der PE-Schätzeinrichtung sichert, daß die Parameter $\alpha_o$ . $\alpha_1$ und $\beta_1$ durch die Minimierung der Abweichung von geschätztem und gemessenem Wandlersekundärstrom immer die tatsächlichen Verhältnisse der auszumessenden Leiterschleife widerspiegeln.

Da die geschätzten Parameter $\underline{\Theta}$ die Koeffizienten der Filtereinrichtung

$$G(z^{-1}) = \frac{\alpha_1 z^{-1} + \alpha_o}{1 + \beta_1 z^{-1}}$$

darstellen, kann durch Anwendung der Abbildungsvorschrift des p-Bereiches auf den z-Bereich

$$z = e^{pT_A}$$

wie folgt der 50-Hz-Wert der dem geschätzten Koeffizientensatz entsprechenden Übertragungsfunktion ermittelt werden:

$$\underline{Y}(f_N) = \frac{\alpha_1 e^{-j2\pi f_N} + \alpha_o}{1 + \beta_1 e^{-j2\pi f_N}} .$$

Der reziproke Wert dieses Zeigers repräsentiert den 50-Hz-Wert der Impedanz der Leiterschleife. Die in der Einrichtung $\underline{8}$ erfolgende Transformation der Filterkoeffizienten liefert die Meßwerte R und X.

## Patentansprüche

1. Verfahren zur Ermittlung der betriebsfrequenten Impedanz einer Leiterschleife, bei dem mittels eines Spannungswandlers (2) und eines Hauptstromwandlers (3) Spannungen und Ströme der Leiterschleife gemessen werden,
**dadurch gekennzeichnet**, daß
aus dem gemessenen und hinsichtlich einer Nachbarsystembeeinflussung korrigierten Spannungswert mittels einer Filtereinrichtung 1. Ordnung (6) ein Stromsignal erzeugt wird, welches einen Schätzwert für den Primärstrom in der Leiterschleife darstellt, und dieser Strom mittels eines nichtlinearen Stromwandlermodells (7) in ein Stromsignal umgewandelt wird, welches den Schätzwert des gemessenen Sekundärstroms des Hauptstromwandlers (3) darstellt, wobei mit dem sich aus der Differenz von gemessenem und geschätztem Sekundärstrom ergebenden Modellfehlersignal mittels einer PE-Schätzeinrichtung (9) die Parameter der Filtereinrichtung (6) so nachgeregelt werden, daß der Modellfehler minimal wird, und aus den Parametern der Filtereinrichtung (6) der betriebsfrequente Zeiger der mit diesem Koeffizientensatz und dieser Filterform korrespondierenden Übertragungsfunktion ermittelt wird, dessen Reziprokwert der Impedanz der Leiterschleife entspricht.

2. Schaltungsanordnung zur Ermittlung der betriebsfrequenten Impedanz einer Leiterschleife mit einem Spannungswandler (2) und einem Hauptstromwandler (3) der auszumessenden Leiterschleife, insbesondere zur Durchführung des Verfahrens nach Anspruch 1,
gekennzeichnet durch
einen Nullstromwandler (1) eines Nachbarsystems, ein Meßwerterfassungssystem (4), das die Ausgangssignale des Nullstromwandlers (1), des Spannungswandlers (2) und des Hauptstromwandlers (3) zugeführt erhält und Ausgangssignale $u_{(k)}^{*}$ und $i_{o(k)}$ abgibt, die der erfaßten Spannung bzw. dem erfaßten Strom entsprechen, eine Einrichtung (5) zur Spannungssignalkorrektur, welche die Ausgangssignale $u_{(k)}$ und $i_{o(k)}$ zugeführt erhält und ein Ausgangssignal abgibt, das dem um den Einfluß der Induktion aus dem Nachbarsystem korrigierten Spannungswert $u_{(k)}$ entspricht, eine der Einrichtung (5) zur Spannungssignalkorrektur nachgeschaltete Filtereinrichtung (6) 1. Ordnung, vorzugsweise ein digitales Filter, die das Leitungsmodell darstellt und aus dem dem Spannungswert $u_{(k)}^{*}$ entsprechenden Signal ein dem Strom $\hat{i}_{1(k)}$ entsprechendes Signal erzeugt, das einen Schätzwert für den Primärstrom in der Leiterschleife darstellt, ein der Filtereinrichtung (6) nachgeschaltetes nichtlineares Stromwandlermodell (7), das ein Stromsignal erzeugt, das den Schätzwert $\hat{i}_{2(k)}$ des meßbaren Sekundärstroms des Hauptstromwandlers darstellt, einen Differenzbildner, der das dem Schätzwert $\hat{i}_{2(k)}$ entsprechende Signal mit dem geschätzten Sekundärstrom

$i_{2(k)}$ vergleicht, dessen entsprechendes Signal von Meßwerterfassungssystem (4) zugeführt wird, und als Ausgangssignal ein der Differenz $\hat{e}_{(k)}$ von gemessenen und geschätztem Sekundärstrom entsprechendes Modellfehlersignal abgibt, eine PE-Schätzeinrichtung (9), die das Modellfehlersignal zugeführt erhält und die wechselseitig mit der Einrichtung (5) zur Spannungssignalkorrektur, der Filtereinrichtung (6) sowie einer Einrichtung (8) zur Transformation der Filterkoeffizienten in Verbindung steht, mit deren Ausgangssignalen die Parameter der Filtereinrichtung (6) so nachgeregelt werden, daß der Modellfehler minimal wird, wobei die Schaltungsanordnung so ausgebildet ist, daß aus den Parametern der Filtereinrichtung (6) der betriebsfrequente Zeiger der diesem Filterkoeffizientensatz und dieser Filterform entsprechenden Übertragungsfunktion ermittelt wird, dessen Reziprokwert der Impedanz der Leifterschleife entspricht.

3. Schaltungsanordnung nach Anspruch 2, dadurch gekennzeichnet, daß sie in Form einer programmierbaren Steuerung realisiert ist, die ein digitales Mikroprozessorsystem umfaßt, das die Funktionen der Einrichtung (5) zur Spannungssignalkorrektur, der Filtereinrichtung (6), des Stromwandlermodells (7), der Einrichtung (8) zur Transformation der Filterkoeffizienten und der PE-Schätzeinrichtung (9) sowie ggfs. auch des Meßwerterfassungssystems (4) übernimmt und die Impedanzwertermittlung durchführt.

4. Schaltungsanordnung nach Anspruch 2 oder 3, dadurch gekennzeichnet, daß sie eine Ausgangs- bzw. Ausgabeeinrichtung und/oder eine Anzeigeeinrichtung aufweist, mit denen Ergebniswerte ausgegeben, ausgedruckt und/oder angezeigt werden können.

## Claims

1. Method for determining the impedance of a conductor loop at the operating frequency, with which voltages and currents of the conductor loop are measured by means of a voltage transformer (2) and a series transformer (3), characterised in that from the measured voltage value corrected with respect to the influence of an adjacent system there is produced, by means of a first order filter arrangement (6), a current signal which represents an estimate of the primary current in the conductor loop, and this current is transformed by means of a non-linear current transformer model (7) into a current signal which represents the estimate of the measured secondary current of the series transformer (3), wherein the parameters of the filter arrangement (6) are adjusted by means of a PE estimating device (9) with the model fault signal resulting from the difference between measured and estimated secondary current such that the model fault is minimised and the pointer at the operating frequency of the transfer function which corresponds to this set of coefficients and this filter form and of which the reciprocal value corresponds to the impedance of the conductor loop is determined from the parameters of the filter arrangement (6).

2. Circuit arrangement for determining the impedance of a conductor loop at the operating frequency with a voltage transformer (2) and a series transformer (3) of the conductor loop to be measured, in particular for carrying out the method according to claim 1, characterised by a residual current transformer (1) of an adjacent system, a measured value detecting system (4) which receives the output signals of the residual current transformer (1), the voltage transformer (2) and the series transformer (3), and emits output signals $u_{(k)}^{x}$ and $i_{o(k)}$ which correspond to the detected voltage or the detected current, an arrangement (5) for voltage signal correction which receives output signals $u_{(k)}$ and $i_{o(k)}$ and emits an output signal which corresponds to the voltage value $u_{(k)}$ corrected by the influence of the induction from the adjacent system, a first order filter arrangement (6), preferably a digital filter, which follows the arrangement (5) for voltage signal correction, represents the line model and produces, from the signal corresponding to the voltage value $u_{(k)}^{x}$, a signal corresponding to the current $\hat{i}_{1(k)}$ which represents an estimate of the primary current in the conductor loop, a non-linear current transformer model (7) which follows the filter arrangement (6) and produces a current signal representing the estimate $\hat{i}_{2(k)}$ of the measurable secondary current of the series transformer, a differentiator which compares the signal corresponding to the estimate $\hat{i}_{2(k)}$ with the estimated secondary current $i_{2(k)}$ of which the corresponding signal is supplied by the measured value detection system (4) and emits, as output signal, a model fault signal corresponding to the difference $\hat{e}_{(k)}$ between measured and estimated secondary current, a PE estimating device (9) which receives the model fault signal and is connected alternately to the arrangement (5) for voltage signal correction, the filter arrangement (6) and an arrangement (8) for transformation of the filter coefficient with whose output signals the parameters of the filter arrangement (6) are adjusted such that the model fault is minimised, wherein the circuit arrangement is designed such that the pointer at the operating frequency of the transfer function which corresponds to this set of filter coefficients and this filter form and of which the reciprocal value corresponds to the impedance of the conductor loop is determined from the parameters of the filter arrangement (6).

3. Circuit arrangement according to claim 2, characterised in that it is produced in the form of a programmable controller comprising a digital microprocessor system which takes over the functions of the arrangement (5) for voltage signal correction, of the filter arrangement (6), the current transformer model (7), the arrangement (8) for transformation of the filter coefficients and of the PE estimating device (9) and optionally also of the measured value detection system (4) and carries out impedance value determination.

4. Circuit arrangement according to claim 2 or 3, characterised in that it has an output or delivery arrangement and/or a display arrangement with which results may be delivered, printed out and/or displayed.

## Revendications

1. Procédé pour la détermination de l'impédance à la fréquence de service d'une boucle de conducteur, dans lequel les tensions et les courants de la boucle de conducteur sont mesurées au moyen d'un transformateur de tension (2) et d'un transformateur série (3),
caractérisé en ce que, à partir de la valeur de tension mesurée et corrigée par rapport à l'influence d'un système voisin, un signal de courant est engendré au moyen d'un dispositif à filtre du 1er ordre (6), qui représente une valeur estimative pour le courant primaire dans la boucle de conducteur, et ce courant est transformé en un signal de courant au moyen d'un modèle de transformateur de courant non linéaire (7), lequel représente la valeur estimative du courant secondaire mesuré du transformateur série (3), les paramètres du dispositif à filtre (6) étant rajustés au moyen d'un dispositif d'estimation P-E avec le signal d'erreur modèle fourni par la différence entre les courants secondaires mesuré et estimé de telle manière que l'erreur modèle devienne minimale et, à partir des paramètres du dispositif à filtre (6), l'indicateur à la fréquence de service de la fonction de transfert correspondant à cette loi de coefficients et à cette forme de filtre est déterminé, dont la valeur inverse correspond à l'impédance de la boucle de conducteur.

2. Montage pour la détermination de l'impédance à la fréquence de service d'une boucle de conducteur, avec un transformateur de tension (2) et un transformateur série (3) de la boucle de conducteur à mesurer, caractérisé par un transformateur à courant homopolaire (1) d'un système voisin, un système de détection de valeur de mesure (4) auquel sont amenés les signaux de sortie du transformateur à courant homopolaire (1), du transformateur de tension (2) et du transformateur série (3) et qui émet des signaux de sortie $u_{(k)}$ et $i_{o(k)}$ qui correspondent à la tension ou respectivement au courant détectés, un dispositif (5) pour la correction du signal de tension auquel sont amenés les signaux de sorte $u_{(k)}$ et $i_{o(k)}$ et qui émet un signal de sortie qui correspond à la valeur de tension $u_{(k)}$ corrigée de l'influence de l'induction depuis le système voisin, un dispositif à filtre (6) du 1er ordre intercalé à la suite du dispositif (5) pour la correction du signal de tension, de préférence un filtre numérique, qui représente le modèle de la tension et qui engendre, à partir du signal correspondant à la valeur de tension $u_{(k)}$, un signal correspondant au courant $i_{1(k)}$ qui représente une valeur estimative pour le courant primaire dans la boucle de conducteur, un modèle de transformateur de courant non linéaire (7) intercalé à la suite du dispositif à filtre (6), qui émet un signal de courant qui représente la valeur estimative $i_{2(k)}$ du courant secondaire mesurable, un soustracteur qui compare le signal correspondant à la valeur estimative $i_{2(k)}$ au courant secondaire estimé $i_{2(k)}$, à qui est envoyé le signal correspondant du système de détection de valeur de mesure (4) et qui émet en tant que signal de sortie un signal d'erreur modèle correspondant à la différence $O_{(k)}$ entre les courants secondaires mesuré et estimé, un dispositif d'estimation PE (9) auquel est envoyé le signal d'erreur modèle et qui est relié alternativement au dispositif (5) pour la correction du signal de tension, au dispositif à filtre (6) ainsi qu'à un dispositif (8) pour la transformation des coefficients de filtre, avec les signaux de sortie duquel les paramètres du dispositif à filtre (6) sont rajustés de telle manière que l'erreur modèle devienne minimale, le montage étant réalisé de telle sorte que, à partir des paramètres du dispositif à filtre (6), l'indicateur à la fréquence de service de la fonction de transfert correspondant à cette loi de coefficients de filtre et à cette forme de filtre est déterminé, dont la valeur inverse correspond à l'impédance de la boucle de conducteur.

3. Montage selon la revendication 2,
caractérisé en ce qu'il est réalisé sous la forme d'une commande programmable qui comprend un système à microcalculateur numérique qui prend en charge les fonctions du dispositif (5) pour la correction du signal de tension, du dispositif à filtre (6), du modèle de transformateur de courant (7), du dispositif (8) pour la transformation des coefficients de filtre et du dispositif d'estimation PE (9) ainsi que, le cas échéant, également du système de détection de valeur de mesure (4) et effectue la détermination de la valeur d'impédance.

4. Montage selon la revendication 2 ou 3,
caractérisé en ce qu'il présente un dispositif de sortie ou respectivement d'extraction et/ou un dispositif d'affichage, par lesquels des valeurs de résultat peuvent être extraites, imprimées et/ou affichées.

$u_{(k)}$ $i_{0(k)}$ $i_{2(k)}$

$\hat{u}^\#_{(k)}$ $\hat{i}_{1(k)}$ $\hat{i}_{2(k)}$ $\hat{e}_{(k)}$

R, X